Europäisches Patentamt

European Patent Office

Office européen des brevets

(19)

(11) **EP 0 704 902 B1**

(12) **EUROPÄISCHE PATENTSCHRIFT**

(45) Veröffentlichungstag und Bekanntmachung des Hinweises auf die Patenterteilung:
**04.12.2002 Patentblatt 2002/49**

(51) Int Cl.⁷: **H01L 27/02**, H01L 29/78

(21) Anmeldenummer: **95114638.0**

(22) Anmeldetag: **18.09.1995**

(54) **Verwendung eines Leistungshalbleiterbauelements mit monolithisch integrierter Sensoranordnung**

Application of Power semiconductor device with monolithically integrated sense device

Application d'un dispositif semi-conducteur de puissance avec élément détecteur monolithiquement intégré

(84) Benannte Vertragsstaaten:
**CH DE GB IT LI**

(30) Priorität: **29.09.1994 DE 4434894**

(43) Veröffentlichungstag der Anmeldung:
**03.04.1996 Patentblatt 1996/14**

(73) Patentinhaber: **Infineon Technologies AG
81669 München (DE)**

(72) Erfinder:
 • **Hierold, Christofer, Dr.
 D-81739 München (DE)**
 • **Schwarzbauer, Herbert, Dr.
 D-81373 München (DE)**

(74) Vertreter: **Zimmermann & Partner
Postfach 33 09 20
80069 München (DE)**

(56) Entgegenhaltungen:
**WO-A-89/08928          US-A- 5 153 696**

## Beschreibung

Leistungshalbleiterbauelement mit monolithisch integrierter Sensoranordnung zur temperaturunabhängigen Ermittlung des Laststroms sowie Verfahren zu dessen Ermittlung während des Betreibens des Leistungshalbleiterbauelements.

Die Temperatur, der Laststrom und die Sättigungsspannung (Durchlaßspannung) eines Leistungshalbleiterbauelements, zum Beispiel eines IGBTs oder MOS-FETs, sind wichtige Betriebsgrößen, deren Kenntnis für einen störungsfreien und sicheren Betrieb einer elektrischen Schaltung mit Leistungshalbleiterbauelementen von Vorteil ist, Überlastzustände rechtzeitig erkannt und gegebenenfalls geeignete Gegenmaßnahmen zum Schutz des Bauelements und angeschlossener Verbraucher eingeleitet werden können.

IGBT's mit integrierten Sensoren zur Laststromerfassung sind beispielsweise aus dem Artikel von Bodo Arlt mit dem Titel "IGBT-Technik vom Erfinder" in der Zeitschrift Elektronik Industrie 1 - 1992, Seiten 14 bis 18 bekannt. Dabei wird mit Hilfe eines Stromspiegels ein Meßstrom erzeugt, der mit Hilfe eines externen Widerstandes in eine zum Laststrom proportionale Meßspannung umgesetzt wird.

Eine Temperaturerhöhung, bei zum Beispiel konstantem Laststrom, führt hierbei jedoch zu einer Erhöhung der Meßspannung und täuscht damit einen erhöhten Laststrom vor. Der dadurch entstehende Meßfehler tritt besonders dann auf, wenn der Meßwiderstand innerhalb der aktiven Fläche des Leistungshalbleiters integriert und gemeinsam mit dem Bauelement infolge des Laststromes erwärmt wird.

Aus der internationalen Anmeldung WO 89/08928 ist ein Leistungshalbleiterbauelement mit zum Lasttransistor in Reihe geschalteten Sensorzellen mit jeweils einem Widerstand bekannt, an denen jeweils eine den Laststrom und die Gesamtspannung des Leistungshalbleiterbauelements repräsentierende Spannung abgreifbar ist. Dadurch soll die Bestimmung der Leistung, des on-Widerstandes und der Temperatur des Leistungshalbleiterbauelements ermöglicht werden. Die Bestimmung des Laststroms weist jedoch aufgrund der Temperaturabhängigkeit der Widerstände einen temperaturbehafteten, mittels dieser Sensoranordnung nicht kompensierbaren Fehler auf.

Aus der US-Anmeldung 5,153,696 ist ein MOS-FET mit einem Stromsensoranschluß bekannt, bei dem ein Polysiliziumfilm-Widerstand zwischen der Sourceelektrode und einem Miller-Kontakt vorhanden ist, um externes Rauschen auf Grund eines externen Sensor-Widerstandes zu vermeiden.

Die der Erfindung zugrundeliegende Aufgabe besteht nun darin, ein Leistungshalbleiterbauelement anzugeben, das einen integrierten Stromsensor mit integriertem Meßwiderstand aufweist, bei dem trotzdem eine temperaturunabhängige Laststromermittlung möglich ist.

Diese Aufgabe wird erfindungsgemäß durch die Merkmale der Patentansprüche 1 und 7 gelöst.

Die Merkmale Ansprüche 2 bis 6 betreffen vorteilhafte Ausgestaltungen des erfindungsgemäßen Leistungshalbleiterbauelement, wobei die Merkmale der Ansprüche 4 bis 6 eine zusätzlich ermöglichte Ermittlung der Sättigungsspannung des Leistungshalbleiterbauelementes betreffen.

Die Merkmale des Patentanspruchs 7 sind auf ein Verfahren zur temperaturunabhängigen Bestimmung des Laststrom des Leistungshalbleiterbauelement bei dessen Betreiben gerichtet.

Die Erfindung wird nachfolgend anhand der Zeichnungen näher erläutert. Dabei zeigt:

Figur 1    ein vereinfachtes Ersatzschaltbild eines erfindungsgemäßen Bauelements,

Figur 2    ein Ersatzschaltbild eines Teiles des erfindungsgemäßen Bauelementes unter anderem zur Erläuterung der Ermittlung der Sättigungsspannung,

Figur 3    eine Darstellung eines Teiles eines erfindungsgemäßen Bauelements in der Draufsicht und

Figur 4    eine Schnittdarstellung eines erfindungsgemäßen Bauelements zur Erläuterung der prozeßkompatiblen Herstellung einer Widerstandsbahn.

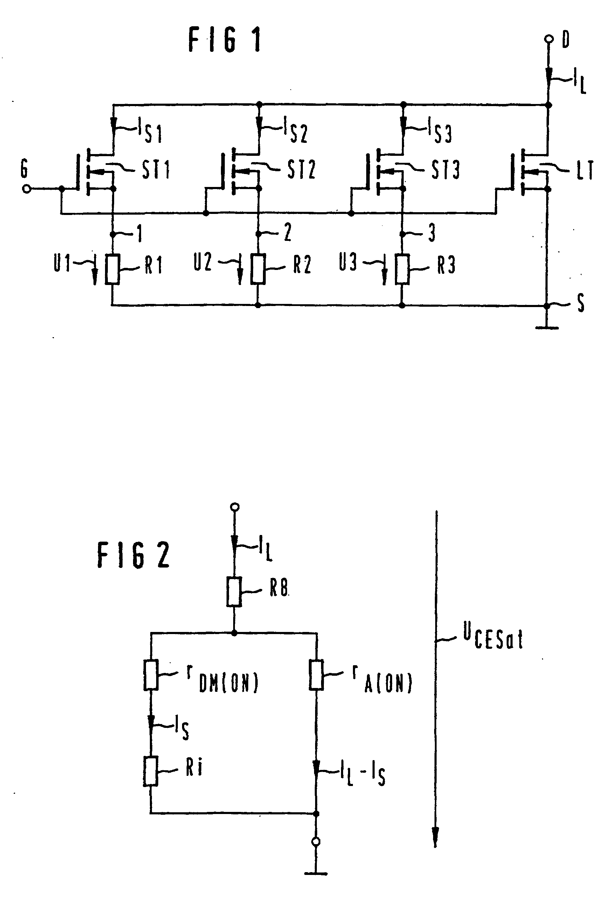

Figur 1 zeigt ein vereinfachtes statisches Ersatzschaltbild eines erfindungsgemäßen Leistungs-MOSFETs, mit mehreren, zum Beispiel drei, Sensortransistoren ST1..ST3 und entsprechend vielen Meßwiderständen. Die Sensortransistoren und Meßwiderstande sind dabei zusammen mit dem Lasttransistor monolithisch integriert und jeweils als Stromspiegel geschaltet, wobei die Gate-Anschlüsse der Sensortransistoren ST1..ST3 und des Lasttransistors LT mit einem gemeinsamen externen Gate-Anschluß G , die Drain-Anschlüsse Sensortransistoren ST1..ST3 und des Lasttransistors LT mit einem gemeinsamen externen Drainanschluß D und jeweilige Source-Anschlüsse 1..3 der Sensortransistoren ST1..ST3 über jeweilige Meßwiderstände R1..R3 und der Source-Anschluß des Lasttransistors LT direkt mit einem gemeinsamen externen Source-Anschluß S verbunden sind.

Die Source-Anschlüsse 1..3 der Sensortransistoren sind extern als Bauelementeanschlüsse verfügbar und führen, bezogen auf das Bezugspotential des Source-Anschlusses S, Meßspannungen U1..U3, die Spannungsabfälle an den Meßwiderständen R1..R3 infolge von zum Laststom $I_L$ proportionaler Spiegelströme $I_{S1}..I_{S3}$ darstellen.

In Figur 2 ist ein Ersatzschaltbild eines Teiles des erfindungsgemäßen Bauelementes dagestellt, wobei der dargestellte Teil einen Stromspiegel aus einem jeweiligen Sensortransistor, dem Lasttransistor und dem Meßwiderstand Ri im eingeschalteten Zustand wiedergibt. Das Ersatzschaltbild besteht aus einem sogenannten Bulk-Widerstand $R_B$, der beiden, Lasttransistor und Spiegeltransistor gemeinsam ist, einem On-Widerstand $r_{DM(on)}$ des Sensortransistors, einem On-Widerstand $r_{A(on)}$ des Lasttransistors und dem Meßwiderstand Ri, wobei der Widerstand $r_{DM(on)}$ und der Meßwiderstand Ri in Reihe geschaltet sind, der Widerstand $r_{A(on)}$ hierzu parallel und dieser Parallelschaltung der Widerstand $R_B$ wiederum in Reihe geschaltet sind.

Sobald ein Laststrom $I_L$ fließt, fließt ein Spiegelstom IS durch den Widerstand $r_{DM(on)}$ und den Meßwiderstand Ri und ein Strom IL - IS durch den Widerstand $r_{A(on)}$, wobei über der gesamten Reihenschaltung die Sättigungsspannung $U_{CEsat}$ anliegt. Wird der Wert eines Meßwiderstandes relativ groß gewählt, so liegt am Meßwiderstand nahezu die volle Sättigungsspannung $U_{CEsat}$.

Im Falle einer Spannungsmessung, also für $R_i \gg r_{DM(on)}$, gilt näherungsweise:

$$U_i = [r_{A(on)}/(r_{A(on)} + R_B)]^*U_{CEsat};$$

Im Falle einer Strommessung, also für $R_i \ll r_{DM(on)}$, gilt näherungsweise:

$$U_i = 1/(SF-1) \, {}^*R_i \, I_L$$

mit $r_{DM(on)}/r_{A(on)}$ als Stromspiegelfaktor SF.

Diese beiden Beziehungen beschreiben zwei Betriebszustände für Stromspiegel, die zur Strom- und Spanhungsmessung ausgenutzt werden können.

Die Widerstände des Ersatzschaltbildes, $r_B$, $r_{DM(on)}$, $R_{A(on)}$ $R_i$ sind temperaturabhängig. Im Bteriebszustand führt eine Temperaturerhöhung, bei zum Beispiel konstantem Laststrom, dann zu einer Erhöhung von Meßspannung $U_i$ und täuscht damit einen erhöhten Laststrom $I_L$ vor. In erster Näherung kann der Zusammenhang zwischen $U_i$, $I_L$ und $\Delta T$ wie folgt beschrieben werden:

$$U_i = (k1 + k2\Delta T)^*I_L = k1^*I_L + k2^*\Delta T \, I_L$$

mit k1, k2 als Proportionalitätskonstanten

Ohne zusätzliche Information über die Temperaturänderung $\Delta T$ ist damit keine eindeutige Bestimmung von $I_L$ mit nur einem Stromspiegel möglich.

Folgendes Gleichungssystem beschreibt eine Sensoranordnung mit zwei Stromspiegeln in erster Näherung:

$$U1 = (k11 + k12\Delta T)^*I_L = k11^*I_L + K12^* \, \Delta T \, I_L$$

mit k11, k12 als Proportionalitätskonstanten.

$$U2 = (k21 + K22\Delta T)^*I_L = k21^*I_L + K22^* \, \Delta T \, I_L$$

mit k21, k22 als Proportionalitätskonstanten.

$$\begin{pmatrix} U1 \\ U2 \end{pmatrix} = \begin{pmatrix} k11 & k12 \\ k21 & k22 \end{pmatrix} * \begin{pmatrix} I_L \\ \Delta T * I_L \end{pmatrix} = K * \begin{pmatrix} I_L \\ \Delta T * I_L \end{pmatrix}$$

Ist K invertierbar, so können die gesuchten Größen $I_L$ und $\Delta T$ in Abhängigkeit der Sensorspannungen wie folgt eindeutig ermittelt werden:

3

$$\begin{pmatrix} I_L \\ \Delta T * I_L \end{pmatrix} = \mathbf{K}^{-1} * \begin{pmatrix} U1 \\ U2 \end{pmatrix}$$

Werden anstelle von zwei Stromspiegeln drei Stromspiegel vorgesehen, wobei der dritte Stromspiegel mit einem Meßwiderstand R3 zur Bestimmung der Sättigungsspannung $U_{CEsat}$ dienen kann, so kann die Sensoranordnung durch folgendes Gleichungssystem beschrieben werden.

$$\begin{pmatrix} U1 \\ U2 \\ U3 \end{pmatrix} = \begin{pmatrix} k11 & k12 & k13 \\ k21 & k22 & k23 \\ k31 & k32 & k33 \end{pmatrix} * \begin{pmatrix} I_L \\ \Delta T * I_L \\ U_{CEsat} \end{pmatrix} = \mathbf{K} * \begin{pmatrix} I_L \\ \Delta T * I_L \\ U_{CEsat} \end{pmatrix}$$

Durch geeignete Dimensionierung der Stromspiegel und der Meßwiderstände können die Proportionalitätskonstanten k13, k23, k31, k32 vernachlässigt werden und dieses Gleichungssystem zerfällt in ein zweidimensionales Gleichungssystem und eine . Bestimmungsgleichung für $U_{CEsat}$. Ist K invertierbar, so können die gesuchten Größen $I_L$, $\Delta T$ und $U_{CEsat}$ in Abhängigkeit der Sensorspannungen wie folgt eindeutig angegeben werden:

$$\begin{pmatrix} I_L \\ \Delta T * I_L \\ U_{CEsat} \end{pmatrix} = \mathbf{K}^{-1} * \begin{pmatrix} U1 \\ U2 \\ U3 \end{pmatrix}$$

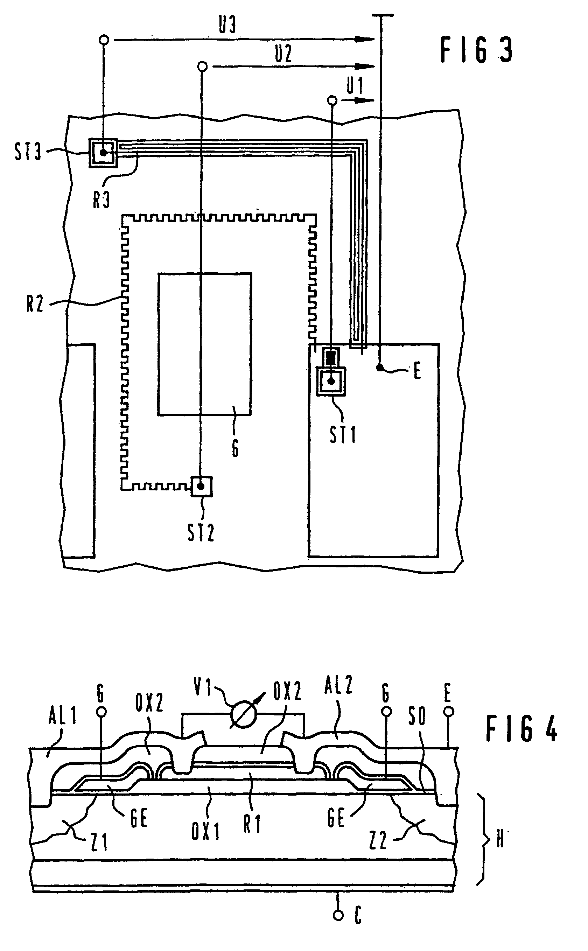

In Figur 3 ist eine Darstellung eines Teiles eines erfindungsgemäßen Bauelements, beispielsweise eines IGBTs mit drei Sensortransistoren ST1..ST3 und drei Meßwiderständen R1..R3, in der Draufsicht dargestellt. Die Meßwiderstände sind hierbei alle mit einer gemeinsamen Hauptelektrode, beispielsweise der Emitterelektrode E, einseitig verbunden und am anderen Ende des jeweiligen Meßwiderstandes liegen die Meßspannungen U1..U3 an.

Der Widerstand R1 besteht vorteilhafterweise aus Polysilizium und die daran abfallende Spannung U1 dient zur Messung des Laststromes $I_L$. Der Widerstand R2 besteht vorteilhafterweise aus Aluminium und die daran abfallende Spannung U2 zur dient zur Messung der Temperatur $\Delta T$. Der Widerstand R3 besteht vorteilhafterweise aus Polysilizium und die daran abfallende Spannung U3 dient zur Messung der Sättigungsspannung $U_{CEsat}$.

Ein typisches Beispiel für eine geeignete Dimensionierung der Meßwiderstände besteht in einem Widerstandswert von jeweils etwa 10 Ohm für die Meßwiderstände R1 un R2 und in einem Widerstandswert von etwa >=10 kOhm für den Meßwiderstand R3.

Durch geeignete Dimensionierung der Stromspiegel, durch eine entsprechende Anzahl von Transistorzellen, und durch eine geeignete Wahl des Materials der Meßwiderstände kann die Genauigkeit der Sensoranordnung erhöht werden. Ein Stromspiegel mit großer Zellenanzahl, zum Beispiel mit 12 Zellen, und einem Meßwiderstands aus Polysilizium mit einem geringen Temperaturkoeffizienten von ca. 0,1 %/K ist zur Messung von $I_L$ geeignet. Wegen des hohen Schichtwiderstandes von Polysilizium von ca. 9 Ohm/Square kann damit auch ein großer Meßwiderstand von beispielsweise > 10 kOhm mit relativ wenig Platzbedarf hergestellt werden, der zusammen mit einem Stromspiegel niedriger Zellenanzahl, zum Beispiel < 6 Zellen, als Sensor für $U_{CEsat}$ gut geeignet ist. Aluminium kann vorteilhafterweise wegen seines höheren Temperaturkoeffzienten von ca. 0,4 %/K als Widerstandsmaterial für einen Sensor zur Temperaturermittlung verwendet werden.

In Figur 4 ist eine Schnittdarstellung eines erfindungsgemäßen Leistungshalbleiterbauelements dargestellt, das einen Halbleiterkörper H aufweist, auf dessen Strukturierungsoberfläche SO eine nichtleitende Schicht OX1, bei-spielsweise eine $SiO_2$-Schicht, vorgesehen ist, die sowohl eine Gate-Elektrode GE als auch eine Widerstandsbahn für den Meßwiderstand R1 vom Halbleiterkörper H isoliert. Diese Widerstandsbahn liegt dabei in einem lateralen Bereich zwischen jeils zwei Zellen, wobei eine Zelle Z1 eine Zelle eines Sensortransistors und eine Zelle Z2 des Lasttransistors LT bildet und besteht, wie die Gateelektrode, aus Polysilizium. Eine weitere nichtleitende Schicht OX2, beispielsweise aus $SiO_2$, trennt eine aus zwei getrennten Gebieten AL1 und Al2 bestehende metallische Kontaktierungsschicht, die beispielsweise aus Aluminium besteht, von der Gate-Elektrode GE. Das Gebiet AL1 verbindet, durch

4

Aussparungen in der weiteren Oxidschicht hindurch, Zellen Z1 des Sensortransistors mit einem ersten Ende und das Gebiet AL2, das die Kontaktierungsschicht für eine Hauptelektrode, beispielsweise der Elektrode für einen Emitter-Anschluß E, darstellt, Zellen Z2 des Lasttransistors mit dem anderen Ende der Widerstandsbahn für den Widerstand R1. Die Gate-Elektrode GE ist mit einem Gate-Anschluß G und eine der Strukturierungsoberfläche SO abgewandte Oberfläche des Halbleiterkörpers H ist mit einer weiteren Hauptelektrode, beispielsweise der Elektrode für einen Kollektoranschluß C, verbunden.

Der hochohmige Widerstand R3 kann ähnlich wie der Widerstand R1 hergestellt werden, der Unterschied beispielsweise lediglich im Verlauf beziehungsweise in der Länge der jeweiligen Widerstandsbahn.

Die Widerstände R1 und R3 werden vorzugsweise gemeinsam mit der Gateelektrode GE und der Widerstand R2 gemeinsam mit den Gebieten AL1 und AL2 hergestellt.

Durch eine gezielte Dotierung des Polysilizium, die jedoch eine Änderung des herkömmlichen Herstellungsprozesses bedeutet, kann dessen Temperaturkoeffizient in weiten Bereichen von negativen bis positiven Werten eingestellt werden.

Derartige Maßnahmen verstärken den Einfluß der Hauptdiagonalelemente der Matrix K gegenüber den der Nebendiagnoalelemente. Im Idealfall können die Nebendiagonalelemente vernachlässigt werden und obiges Gleichungssystem zerfällt in unabhängige Bestimmungsgleichungen für die Meßgrößen. Dies führt zu einer Erhöhung der Meßgenauigkeit und zu einer Vereinfachung der Auswertung der Sensorsignale.

Zur Messung der Größen $I_L$, $\Delta T$ und $U_{CEsat}$ können auch Sensoranordnungen mit mehr als drei Sensortransistoren und Meßwiderständen Anwendung finden. Die zusätzliche Information (Redundanz) erhöht die Meßgenauigkeit durch Reduzierung des Einflusses statistischer Meßwertschwankunen (Rauschen) und ermöglicht die Berücksichtigung nichtlinearer Anteile in den Abhängigkeiten der Meßspannungen Ui von den Einflußgrößen $I_L$, $U_{CEsat}$ und insbesondere $\Delta T$.

Folgendes Gleichungssystem beschreibt den Zusammenhang zwischen den Meßspannungen Ui und den Einflußgrößen $I_L$, $\Delta T$ und $U_{CEsat}$ für eine Sensoranordnung mit p (p>=3) Sensoren:

$$\begin{pmatrix} U1 \\ U2 \\ U3 \\ \vdots \\ Up \end{pmatrix} = \begin{pmatrix} k11 & k12 & k13 \\ k21 & k22 & k23 \\ k31 & k32 & k33 \\ \vdots & & \\ kp1 & kp2 & kp3 \end{pmatrix} * \begin{pmatrix} I_L \\ \Delta T * I_L \\ U_{CEsat} \end{pmatrix} = \mathbf{K} * \begin{pmatrix} I_L \\ \Delta T * I_L \\ U_{CEsat} \end{pmatrix}$$

Ist $K^T * K$ invertierbar, wobei $K^T$ die transponierte Matrix K ist, so können die gesuchten Größen $I_L$, $\Delta T$ und $U_{CEsat}$ in Abhängigkeit der Sensorspannungen wie folgt angegeben werden:

$$\begin{pmatrix} I_L \\ \Delta T * I_L \\ U_{CEsat} \end{pmatrix} = \mathbf{K}^+ * \begin{pmatrix} U1 \\ U2 \\ U3 \\ \vdots \\ Up \end{pmatrix}$$

mit der Pseudoinversen $K^+ = (K^T * K)^{-1} * K^T$.

**Patentansprüche**

**1.** Leistungshalbleiterbauelement,

- bei dem neben einem Lasttransistor (LT) mindestens zwei weitere Transistoren (ST1, ST2) und mindestens zwei Widerstände (R1, R2) monolithisch integriert sind,
- bei dem eine erste Reihenschaltung aus dem ersten weiteren Transistor (ST1) und dem ersten Widerstand (R1) zusammen mit dem Lasttransistor (LT) einen ersten Stromspiegel bildet, und

- bei dem eine zweite Reihenschaltung aus dem zweiten weiteren Transistor (ST2) und dem zweiten Widerstand (R2) zusammen mit dem Lasttransistor (LT) einen zweiten Stromspiegel bildet,
- wobei über dem erstenWiderstand (R1) während des Betreibens des Leistungshalbleiterbauelements eine den Laststrom ($I_L$) des Leistungshalbleiterbauelements repräsentierende Spannung abgreifbar ist,

**dadurch gekennzeichnet, daß**

- die jeweiligen Widerstandsbahnen der Widerstände aus Materialien mit unterschiedlichen Temperaturkoeffizienten bestehen, und
- die über dem zweiten Widerstand (R2) während des Betreibens des Leistungshalbleiterbauelements abgreifbare Spannung zur Ermittlung der Temperatur des Leistungshalbleiterbauelements dient.

2. Leistungshalbleiterbauelement nach Anspruch 1,
   **dadurch gekennzeichnet, daß**
   das Material des ersten Widerstandes (R1) im wesentlichen aus Polysilizium (POLY) und das Material des zweiten Widerstandes (R2) im wesentlichen aus Aluminium (AL) besteht.

3. Leistungshalbleiterbauelement nach Anspruch 2,
   **dadurch gekennzeichnet, daß**
   das Polysilizium zur Einstellung seines Temperaturkoeffizienten dotiert ist.

4. Leistungshalbleiterbauelement nach einem der vorherigen Ansprüche,
   **dadurch gekennzeichnet, daß**
   zusätzlich eine dritte Reihenschaltung aus einem dritten weiteren Transistor (ST3) und einem dritten Widerstand (R3) zusammen mit dem Lasttransistor (LT) einen dritten Stromspiegel bildet, wobei der dritte Widerstand (R3) im wesentlichen aus Polysilizium besteht und mindestens zwei Größenordnungen hochohmiger als der erste und der zweite Widerstand (R1, R2) ist, so daß während des Betreibens des Leistungshalbleiterbauelements über dem dritten Widerstand (R3) eine die Sättigungsspannung ($U_{CEsat}$) des Leistungshalbleiterbauelements repräsentierende Spannung abgreifbar ist.

5. Leistungshalbleiterbauelement nach Anspruch 4,
   **dadurch gekennzeichnet, daß**
   der ersten und der dritte weitere Transistor (ST1, ST3) jeweils aus einzelnen Zellen besteht, wobei der dritte weitere Transistor (ST3) weniger als die Hälfte der Anzahl von Zellen des ersten weiteren Transistors (ST1) aufweist.

6. Leistungshalbleiterbauelement nach Anspruch 4 oder 5,
   **dadurch gekennzeichnet, daß**
   die erste Reihenschaltung (ST1, R1) und/oder die zweite Reihenschaltung (ST2, R2) und/oder die dritte Reihenschaltung (ST3, R3) mehrfach vorgesehen ist.

7. Verfahren zur Ermittlung der Temperatur und des Laststroms während des Betreibens eines Leistungshalbleiterbauelements nach einem der Ansprüche 1 bis 6, mit den Schritten:

   - eine erste Meßspannung ($U_1$) wird am ersten Widerstand (R1) und
   - eine zweite Meßspannung ($U_2$) wird am zweiten Widerstand (R2) abgegriffen,
   - der Laststrom ($I_L$) und die Temperatur des Leistungshalbleiterbauelements werden mittels der Beziehung

$$\begin{pmatrix} U_1 \\ U_2 \end{pmatrix} = \begin{pmatrix} k_{11} & k_{12} \\ k_{21} & k_{22} \end{pmatrix} * \begin{pmatrix} I_L \\ \Delta T * I_L \end{pmatrix}$$

   ermittelt, wobei $k_{1n}$ und $k_{2n}$ mit n=1,2 die Stromspiegel des Leistungshalbleiterbauelements repräsentierende Proportionalitätskonstanten sind.

8. Verfahren nach Anspruch 7,

**dadurch gekennzeichnet, daß**

zusätzlich eine dritte Meßspannung ($U_3$) am dritten Widerstand abgegriffen wird und neben der Temperatur und dem Laststrom die Sättigungsspannung ($U_{CEsat}$) des Leistungshalbleiterbauelements mittels der Beziehung

$$\begin{pmatrix} U_1 \\ U_2 \\ U_3 \end{pmatrix} = \begin{pmatrix} k_{11} & k_{12} & k_{13} \\ k_{21} & k_{22} & k_{23} \\ k_{31} & k_{32} & k_{33} \end{pmatrix} * \begin{pmatrix} I_L \\ \Delta T * I_L \\ U_{CEsat} \end{pmatrix}$$

ermittelt wird, wobei $k_{1n}$, $k_{2n}$ und $k_{3n}$ mit n=1,2,3 die Stromspiegel des Leistungshalbleiterbauelements repräsentierende Proportionalitätskonstanten sind.

9. Verfahren nach Anspruch 8,
**dadurch gekennzeichnet, daß**
zur Erhöhung der Meßgenauigkeit wenigstens einer der drei Stromspiegel (ST1, R1, ST2, R2, ST3, R3) mehrfach vorhanden ist und zur Ermittlung einer weiteren Meßspannung ($U_p$) dient, so daß insgesamt p Stromspiegel zur Verfügung stehen, wobei die Temperatur, der Laststrom ($I_L$) und die Sättigungsspannung ($U_{CEsat}$) mittels der Beziehung

$$\begin{pmatrix} U_1 \\ \vdots \\ U_p \end{pmatrix} = \begin{pmatrix} k_{11} & \cdots & k_{13} \\ \vdots & \ddots & \vdots \\ k_{p1} & \cdots & k_{p3} \end{pmatrix} * \begin{pmatrix} I_L \\ \Delta T * I_L \\ U_{CEsat} \end{pmatrix}$$

ermittelt werden, wobei $k_{1n}$ bis $k_{jn}$ mit n=1,2,3 und j=1...p die Stromspiegel des Leistungshalbleiterbauelements repräsentierende Proportionalitätskonstanten sind.

## Claims

1. Power semiconductor device,

   - in which, along with a load transistor (LT), at least two further transistors (ST1, ST2) and at least two resistors (R1, R2) are monolithically integrated,
   - in which a first series connection, comprising a first further transistor (ST1) and a first resistor (R1), together with the load transistor (LT) forms a first current mirror, and
   - in which a second series connection, comprising the second further transistor (ST2) and the second resistor (R2), together with the load transistor (LT) forms a second current mirror,
   - it being possible for a voltage representing the load current ($I_L$) of the power semiconductor device to be picked off over the first resistor (R1) during the operation of the power semiconductor device,

   **characterized in that**

   - the respective resistor runs of the resistors consist of materials with different temperature coefficients, and
   - the voltage which can be picked off over the second resistor (R2) during the operation of the power semiconductor device serves for the determination of the temperature of the power semiconductor device.

2. Power semiconductor device according to Claim 1, **characterized in that** the material of the first resistor (R1) consists essentially of polysilicon (POLY) and the material of the second resistor (R2) consists essentially of aluminium (AL).

3. Power semiconductor device according to Claim 2, **characterized in that** the polysilicon is doped for setting its temperature coefficient.

4. Power semiconductor device according to one of the preceding claims, **characterized in that**, in addition, a third series connection, comprising a third further transistor (ST3) and a third resistor (R3), together with the load transistor (LT) forms a third current mirror, the third resistor (R3) consisting essentially of polysilicon and having an impedance at least two orders of magnitude greater than that of the first and second resistors (R1, R2), so that a voltage representing the saturation voltage ($U_{CEsat}$) of the power semiconductor device can be picked off over the third resistor (R3) during the operation of the power semiconductor device.

5. Power semiconductor device according to Claim 4, **characterized in that** the first and third further transistors (ST1, ST3) in each case comprise individual cells, the third further transistor (ST3) having fewer than half the number of cells of the first further transistor (ST1).

6. Power semiconductor device according to Claim 4 or 5, **characterized in that** the first series connection (ST1, R1) and/or the second series connection (ST2, R2) and/or the third series connection (ST3, R3) is provided multiply.

7. Method for determining the temperature and the load current during the operation of a power semiconductor device according to one of Claims 1 to 6, with the following steps:

   - a first measuring voltage ($U_1$) is picked off at the first resistor (R1) and
   - a second measuring voltage ($U_2$) is picked off at the second resistor ($R_2$),
   - the load current ($I_L$) and the temperature of the power semiconductor device are determined by means of the relationship

$$\begin{pmatrix} U_1 \\ U_2 \end{pmatrix} = \begin{pmatrix} k_{11} & k_{12} \\ k_{21} & k_{22} \end{pmatrix} * \begin{pmatrix} I_L \\ \Delta T * I_L \end{pmatrix}$$

where $k_{1n}$ and $k_{2n}$, with n=1,2, are proportionality constants representing the current mirrors of the power semiconductor device.

8. Method according to Claim 7, **characterized in that**, in addition, a third measuring voltage ($U_3$) is picked off at the third resistor and, in addition to the temperature and the load current, the saturation voltage ($U_{CEsat}$) of the power semiconductor device is determined by means of the relationship

$$\begin{pmatrix} U_1 \\ U_2 \\ U_3 \end{pmatrix} = \begin{pmatrix} k_{11} & k_{12} & k_{13} \\ k_{21} & k_{22} & k_{23} \\ k_{31} & k_{32} & k_{33} \end{pmatrix} * \begin{pmatrix} I_L \\ \Delta T * I_L \\ U_{CEsat} \end{pmatrix}$$

where $k_{1n}$, $k_{2n}$ and $k_{3n}$, with n=1,2,3, are proportionality constants representing the current mirrors of the power semiconductor device.

9. Method according to Claim 8, **characterized in that**, to increase the measuring accuracy, at least one of the three current mirrors (ST1, R1, ST2, R2, ST3, R3) is multiply present and serves for the determination of a further measuring voltage ($U_p$), so that altogether p current mirrors are available, the temperature, the load current ($I_L$) and the saturation voltage ($U_{CEsat}$) being determined by means of the relationship

$$\begin{pmatrix} U_1 \\ \vdots \\ U_p \end{pmatrix} = \begin{pmatrix} k_{11} & \cdots & k_{13} \\ \vdots & \ddots & \vdots \\ k_{p1} & \cdots & k_{p3} \end{pmatrix} \cdot \begin{pmatrix} I_L \\ \Delta T \cdot I_L \\ U_{CEsat} \end{pmatrix}$$

where $k_{1n}$ to $k_{jn}$, with n=1,2,3 and j=1...p, are proportionality constants representing the current mirrors of the power semiconductor device.

**Revendications**

1.  Composant semi-conducteur de puissance,

    -   dans lequel il est intégré monolithiquement, outre un transistor (LT) de charge, au moins deux autres transistors (ST1, ST2) et au moins deux résistances (R1, R2),
    -   dans lequel un premier circuit série constitué du premier autre transistor (ST1) et de la première résistance (R1) forme, ensemble avec le transistor (LT) de charge, un premier miroir de courant, et
    -   dans lequel un deuxième circuit série constitué du deuxième autre transistor (ST2) et de la deuxième résistance (R2) forme, ensemble avec le transistor (LT) de charge, un deuxième miroir de courant,
    -   une tension représentant le courant ($I_L$) de charge du composant semi-conducteur de puissance pouvant être prélevée aux bornes de la première résistance (R1) pendant le fonctionnement du composant semi-conducteur de puissance,

        **caractérisé en ce que**

    -   les pistes résistantes respectives des résistances sont en matériau ayant des coefficients de température différents, et
    -   la tension que l'on peut prélever aux bornes de la deuxième résistance (R2) pendant le fonctionnement du composant semi-conducteur de puissance sert à déterminer la température du composant semi-conducteur de puissance.

2.  Composant semi-conducteur de puissance suivant la revendication 1, **caractérisé en ce que** le matériau de la première résistance (R1) est essentiellement du polysilicium (POLY) et le matériau de la deuxième résistance (R2) est essentiellement de l'aluminium (AL).

3.  Composant semi-conducteur de puissance suivant la revendication 2, **caractérisé en ce que** le polysilicium est dopé pour régler son coefficient de température.

4.  Composant semi-conducteur de puissance suivant l'une des revendications précédentes, **caractérisé en ce qu'**en plus un troisième circuit série constitué d'un troisième autre transistor (ST3) et d'une troisième résistance (R3) forme, ensemble avec le transistor (LT) de charge, un troisième miroir de courant, la troisième résistance (R3) étant essentiellement en polysilicium et ayant une valeur ohmique plus grande d'au moins deux ordres de grandeur que la première et la deuxième résistance (R1, R2), de sorte que pendant le fonctionnement du composant semi-conducteur de puissance on peut prélever aux bornes de la troisième résistance (R3) une tension représentant la tension ($U_{CEsat}$) de saturation du composant semi-conducteur de puissance.

5.  Composant semi-conducteur de puissance suivant la revendication 4, **caractérisé en ce que** le premier et le troisième autre transistor (ST1, ST3) sont constitués respectivement de cellules individuelles, le troisième autre transistor (ST3) ayant moins que la moitié du nombre de cellules du premier autre transistor (ST1).

6.  Composant semi-conducteur de puissance suivant la revendication 4 ou 5, **caractérisé en ce que** le premier circuit (ST1, R1) série et/ou le deuxième circuit (ST2, R2) série et/ou le troisième circuit (ST3, R3) série est prévu plusieurs fois.

7.  Procédé de détermination de la température et du courant de charge pendant le fonctionnement d'un composant semi-conducteur de puissance suivant l'une des revendications 1 à 6, comprenant les étapes :

- on prélève une première tension ($U_1$) de mesure sur une première résistance (R1) et
- on prélève une deuxième tension ($U_2$) de mesure sur une deuxième résistance (R2),
- on détermine le courant ($I_L$) de charge et la température du composant semi-conducteur de puissance au moyen de la relation

$$\begin{pmatrix} U_1 \\ U_2 \end{pmatrix} = \begin{pmatrix} k_{11} & k_{12} \\ k_{21} & k_{22} \end{pmatrix} * \begin{pmatrix} I_L \\ \Delta T * I_L \end{pmatrix}$$

dans laquelle $k_{1n}$ et $k_{2n}$ avec n=1,2 sont des constantes de proportionnalité représentant des miroirs de courant du composant semi-conducteur de puissance.

**8.** Procédé suivant la revendication 7, **caractérisé en ce que** l'on prélève en plus une troisième tension ($U_3$) de mesure sur la troisième résistance et on détermine, outre la température et le courant de charge, la tension ($U_{CEsat}$) de saturation du composant semi-conducteur de puissance au moyen de la relation

$$\begin{pmatrix} U_1 \\ U_2 \\ U_3 \end{pmatrix} = \begin{pmatrix} k_{11} & k_{12} & k_{13} \\ k_{21} & k_{22} & k_{23} \\ k_{31} & k_{32} & k_{33} \end{pmatrix} * \begin{pmatrix} I_L' \\ \Delta T * I_L \\ U_{CEsat} \end{pmatrix}$$

dans laquelle $k_{1n}$, $k_{2n}$ et $k_{3n}$ avec n=1,2,3 sont les constantes de proportionnalité représentant des miroirs de courant du composant semi-conducteur de puissance.

**9.** Procédé suivant la revendication 8, **caractérisé en ce que** pour augmenter la précision de mesure, au moins l'un des trois miroirs (ST1, R1. ST2, R2, ST3, R3) de courant est prévu plusieurs fois et sert à la détermination d'une autre tension ($U_p$) de mesure, de sorte que l'on dispose en tout de p miroirs de courant, la température, le courant ($I_L$) de charge et la tension ($U_{CEsat}$) de saturation étant déterminés au moyen de la relation

$$\begin{pmatrix} U_1 \\ \vdots \\ U_p \end{pmatrix} = \begin{pmatrix} k_{11} & \cdots & k_{13} \\ \vdots & \ddots & \vdots \\ k_{p1} & \cdots & k_{p3} \end{pmatrix} * \begin{pmatrix} I_L \\ \Delta T * I_L \\ U_{CEsat} \end{pmatrix}$$

dans laquelle $k_{1n}$ à $k_{jn}$ avec n=1,2,3 et j=1...p sont des constantes de proportionnalité représentant des miroirs de courant du composant semi-conducteur de puissance.

# FIG 1

# FIG 2

FIG 3

U3

U2

U1

ST3

R3

R2

6

ST1

E

ST2

FIG 4

AL1  G  OX2  V1  OX2  AL2  G  SO  E

GE  OX1  R1  GE

Z1  Z2  H

C